# EUROPEAN PATENT APPLICATION

(11) **EP 4 098 777 A1**
(43) Date of publication of application: **07.12.2022**
(21) Application number: 21746984.0
(22) Date of filing: 04.01.2021
(51) Int. Cl.: C25D 3/32, C25D 3/60, C25D 5/50, C25D 7/00

(54) **TIN OR TIN ALLOY ELECTROPLATING SOLUTION, METHOD FOR FORMING BUMPS, AND METHOD FOR PRODUCING CIRCUIT BOARD**

(30) Priority: 27.01.2020 JP 2020011013; 22.12.2020 JP 2020212144
(71) Applicant: Mitsubishi Materials Corporation, Tokyo 100-8117 (JP)
(72) Inventor: SUSUKI, Kyoka, Naka-shi, Ibaraki 311-0102 (JP); WATANABE, Mami, Naka-shi, Ibaraki 311-0102 (JP); NAKAYA, Kiyotaka, Naka-shi, Ibaraki 311-0102 (JP); TATSUMI, Koji, Sanda-shi, Hyogo 669-1339 (JP); INOUE, Jyunta, Sanda-shi, Hyogo 669-1339 (JP)
(74) Representative: Gille Hrabal Partnerschaftsgesellschaft mbB Patentanwälte
(86) International application number: PCT/JP2021/000008
(87) International publication number: WO 2021/153160

(57) **Abstract**

This tin or tin alloy electroplating solution according to one aspect contains a soluble salt (A) including at least a stannous salt, one or more compounds (B) selected from the group consisting of an organic acid, an inorganic acid, and a salt thereof, a surfactant (C) that is a polyoxyethylene polycyclic phenyl ether sulfuric acid ester salt represented by the following General Formula (1), and a leveling agent (D).

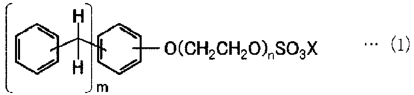

In General Formula (1), m is an integer of 1 to 3, n is an integer of 10 to 30, and X is a cation.

## Description

### TECHNICAL FIELD

The present invention relates to a tin or tin alloy electroplating solution for producing bumps serving as bump electrodes of tin or tin alloy on a substrate when a semiconductor integrated circuit chip is mounted on a circuit substrate. More specifically, the present invention relates to a tin or tin alloy electroplating solution which has excellent via filling property for vias on a substrate even in a pattern having different bump diameters, and which can form bumps having a uniform height. In addition, the present invention relates to a method for forming bumps using a tin or tin alloy electroplating solution, and a method for producing a circuit substrate using these bumps.

The present application claims priority on Japanese Patent Application No. 2020-11013 filed on January 27, 2020, and Japanese Patent Application No. 2020-212144 filed on December 22, 2020, the contents of which are incorporated herein by reference.

### BACKGROUND ART

In a circuit substrate on which a semiconductor integrated circuit chip (hereinafter, referred to as a semiconductor chip) is to be mounted, a chip size/scale package (CSP) type semiconductor device having a package substrate area that is reduced to approximately the same size as that of a semiconductor chip to be mounted on the substrate is currently mainly produced, in order to support lightness, thinness, shortness, and smallness. In order to connect the circuit substrate and the semiconductor chip to each other, via openings which are via bodies on a substrate side are filled with tin or a tin alloy to form bumps which are bump electrodes of protruding metal terminals, and these bumps are loaded with a semiconductor chip.

In the related art, the following method has been adopted to form bumps by filling a tin or tin alloy material. The via bodies are filled with a conductive paste such as a tin-based solder paste or tin-based solder balls, or tin-plating deposition layers are formed in the vias by an electroplating method using a tin or tin-alloy plating liquid. Subsequently, the conductive paste, the solder balls, or the tin plating deposition layers are melted by a heat treatment.

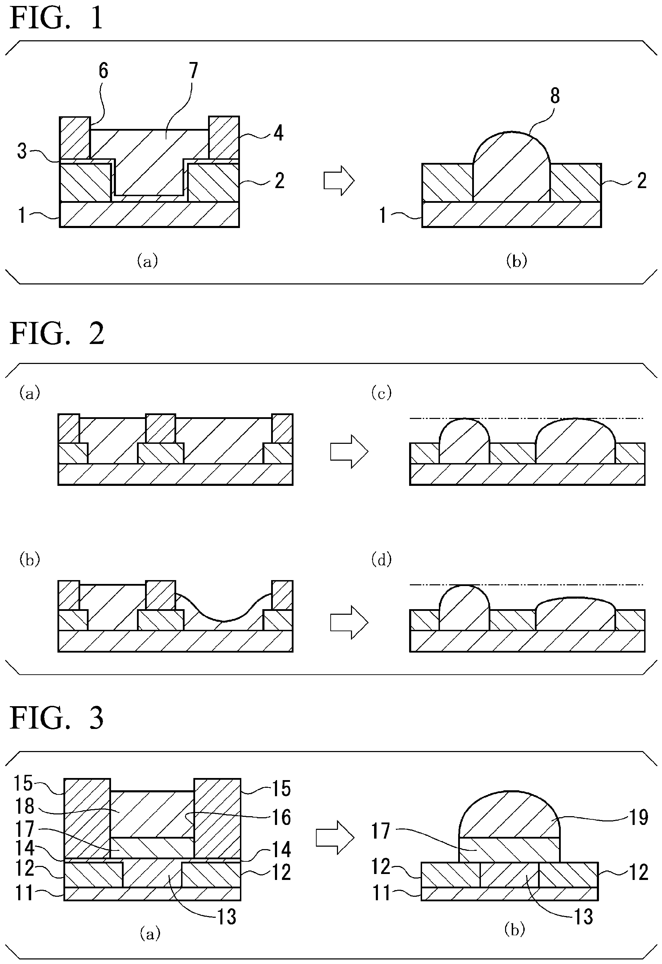

A general method for forming bumps by the electroplating method will be described with reference to FIG. 1. First, as shown in FIG. 1(a), a solder resist pattern having an opening is formed on a surface of a substrate 1 on which wiring or the like is provided. Subsequently, electroless plating is performed on a surface of a solder resist layer 2 to form a copper seed layer 3 for supplying electricity. Subsequently, a dry film resist layer 4 is formed on a surface of the copper seed layer 3, and a dry film resist pattern having an opening is formed so as to be connected to an opening of the solder resist layer 2. Subsequently, by supplying electricity through the copper seed layer 3, tin electroplating is performed in a via 6 of the dry film resist pattern, and a tin plating deposition layer 7 (tin plated film) is formed in the via 6 on the copper seed layer 3. Furthermore, the dry film resist layer 4 and the copper seed layer 3 are sequentially removed, and subsequently, the remaining tin plating deposition layer 7 is melted by a reflow process. As a result, a tin bump 8 is formed as shown in FIG. 1(b).

Previously, in a case of forming tin or tin alloy bumps by the electroplating method, the improvement regarding via filling property of vias on the substrate or prevention of voids in the bumps has been made by changing the components included in the tin or tin alloy plating solution (for example, see Patent Document 1 (claim 2 and paragraph [0020]), Patent Document 2 (claim 1 and paragraphs [0011] and [0012]), Patent Document 3 (claim 1 and paragraph [0019]), and Patent Document 4 (claim 1 and paragraph [0019])).

Patent Document 1 discloses a tin or tin alloy plating solution containing a compound of specific α,β-unsaturated aldehyde or specific α,β-unsaturated ketone. The plating solution of Patent Document 1 has a good via fill effect, and in a case where this plating solution is used, tin plating is selectively deposited in recessed portions. Therefore, a deposit of tin plating that does not substantially has no voids can be obtained. In addition, since no tinting or abnormal precipitation occurs on a surface of the formed tin plated film, a tin plated film is obtained that is excellent in solderability and discoloration resistance and that has a practical and good appearance. The above-described matters are described in Patent Document 1.

In addition, Patent Document 2 discloses a tin or tin alloy plating solution including (a) a carboxyl group-containing compound and (b) a carbonyl group-containing compound, wherein the amount of the component (a) is 1.3 g/L or more, the amount of the component (b) is 0.3 g/L or more, and a molar ratio of the amount of the component (b) to the amount of the component (a) is 10 or less. By electroplating an object to be plated having blind vias or through-holes using this plating solution of Patent Document 2, the blind vias or the through-holes can be filled with high reliability in a short amount of time. In addition, this plating solution can be used for three-dimensional mounting of semiconductors, a step of filling blind vias or through-holes in a printed wiring board, or a formation of silicon through electrodes. The above-described matters are described in Patent Document 2.

Patent Document 3 discloses a tin or tin alloy electroplating solution for forming bump electrodes which contains (A) a soluble salt consisting of either one of a stannous salt or a mixture of a stannous salt and a salt of a metal selected from silver, copper, bismuth, nickel, indium, and gold, (B) an acid or a salt thereof, and (C) a filling organic compound selected from the group consisting of aromatic aldehyde, aliphatic aldehyde, aromatic ketone, and aliphatic ketone, unsaturated carboxylic acids, and aromatic carboxylic acids, and (D) a nonionic surfactant. In the plating solution of Patent Document 3, the component (D) is used in combination with the specific compound (C) that suppresses the precipitation of a tin-based material. Therefore, the precipitation on an upper portion of each via is effectively suppressed, and the precipitation of the tin-based material preferentially proceeds from a bottom portion of each via toward the upper side of the via. Therefore, it is possible to smoothly fill the via while preventing the occurrence of voids. As a result, the bump electrode can be favorably formed with or without reflow, and the bump electrode is excellent in the bonding strength and electrical characteristics. The above-described matters are described in Patent Document 3.

Furthermore, Patent Document 4 discloses a tin or tin alloy plating solution containing one or more selected from inorganic acid, organic acid, and a water-soluble salt thereof, a surfactant, and a leveling agent. The surfactant is at least one nonionic surfactant selected from the group consisting of polyoxyalkylene phenyl ethers, salts thereof, polyoxyalkylene polycyclic phenyl ethers, and salts thereof. The phenyl forming the polyoxyalkylene phenyl ether and the polycyclic phenyl forming the polyoxyalkylene polycyclic phenyl ether may be substituted with an alkyl group having 1 to 24 carbon atoms or a hydroxy group. The leveling agent is composed of two compounds of: (A) at least one selected from the group consisting of aliphatic aldehydes, aromatic aldehydes, aliphatic ketones, and aromatic ketones; and (B) α,β-unsaturated carboxylic acids, amides thereof, or salts thereof. Since the plating solution of Patent Document 4 contains a specific nonionic surfactant and two specific leveling agents, recess filling property (via filling property) is excellent, and it is possible to suppress the occurrence of voids. As a result, by using this plating solution, it is possible to provide good bumps that are smooth without recesses (recessed portion) and do not generate voids after reflow. The above-described matters are described in Patent Document 4.

In recent years, wiring patterns having different bump diameters or bump pitches have been mixed on one circuit substrate. In such complicated wiring patterns, it is necessary to form all bumps at a uniform height, even in a case where the bump diameters and the bump pitches are different. According to the tin or tin alloy plating solutions of Patent Documents 1 to 4, there are advantages that the occurrence of voids in the bumps is prevented, the vias on the substrate can be filled with high reliability in a short period of time, and the via filling property and appearance are excellent. However, the plating solutions for substrates in Patent Documents 1 to 4 do not aim at achieving bump height uniformity.

Specifically, as shown in FIG. 2, in the case of a pattern having different bump diameters, electroplating with a tin or tin alloy electroplating solution in the related art can improve the via filling property of either one of a small diameter or a large diameter, but the via filling property of the other is deteriorate. That is, in a substrate having both vias having a small diameter and a large diameter, in a case of performing the electroplating on both the vias simultaneously, it is difficult to perform the electroplating on both the vias with excellent via filling property. As described above, in a case where vias having different via filling properties are present (FIG. 2(b)), a variation in height of the bumps after the reflow increases, and height uniformity of the bumps cannot be achieved (FIG. 2(d)). Therefore, in order to achieve the height uniformity of the bumps (FIG. 2(c)), as shown in FIG. 2(a), it is necessary to improve via filling properties for both the vias having a small diameter and a large diameter.

### PRIOR ART DOCUMENTS

### Patent Document

Patent Document 1: Japanese Patent No. 6133056
Patent Document 2: Japanese Patent No. 6006683
Patent Document 3: Japanese Unexamined Patent Application, First Publication No. 2016-074963
Patent Document 4: Japanese Unexamined Patent Application, First Publication No. 2015-193916

### DISCLOSURE OF INVENTION

### Problems to be Solved by the Invention

An object of the present invention is to provide a tin or tin alloy electroplating solution which has excellent via filling property for vias on a substrate even in a pattern having different bump diameters, and which can form bumps having a uniform height. Another object of the present invention is to provide a method for forming bumps and a method for producing a circuit substrate using this tin or tin alloy electroplating solution.

### Solutions for Solving the Problems

A first aspect of the present invention is a tin or tin alloy electroplating solution containing (A) a soluble salt including at least a stannous salt, (B) one or more compounds selected from the group consisting of an organic acid, an inorganic acid, and a salt thereof, (C) a surfactant, and (D) a leveling agent, in which the surfactant (C) is one or more selected from the group consisting of polyoxyethylene polycyclic phenyl ether sulfuric acid ester salts represented by General Formulae (1), (2), (3), and (4).

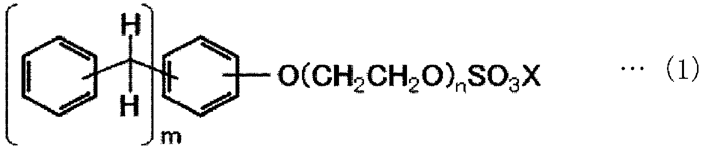

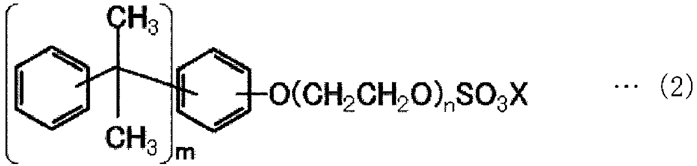

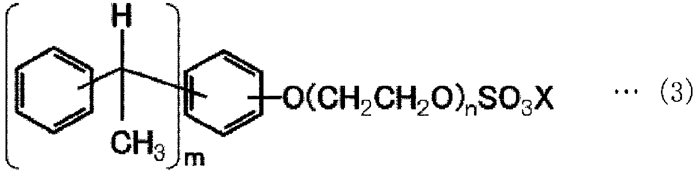

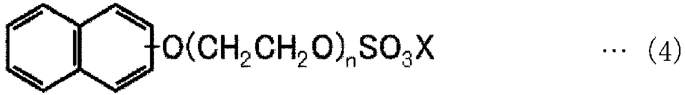

In General Formulae (1), (2), and (3), m is an integer of 1 to 3. In General Formulae (1), (2), (3), and (4), n is an integer of 10 to 30, and X is a cation.

A second aspect of the present invention is the tin or tin alloy electroplating solution according to the first aspect, which further contains two or more of a surfactant other than the surfactant (C), an antioxidant, and an alcohol having 1 to 4 carbon atoms.

A third aspect of the present invention is a method for forming bumps including a step of forming tin or tin alloy electroplating deposition layers on a substrate by using the tin or tin alloy electroplating solution according to the first aspect or the second aspect, and a step of subsequently performing a reflow process to form bumps.

A fourth aspect of the present invention is a method for producing a circuit substrate including a step of producing a circuit substrate by using the bumps formed by the method according to the third aspect.

### Effects of Invention

In the tin or tin alloy electroplating solution of the first aspect of the present invention, the surfactant has a specific anion structure in which the number (m + 1) of phenyl groups and the number n of polyoxyethylene groups in the above-described General Formula (1) and the like are set to be in the predetermined ranges and X is the cation. Therefore, at the time of electroplating, it is possible to suppress precipitation of Sn ions and perform good electroplating on a surface to be electroplated. In particular, according to this electroplating solution, in a case of a pattern having different bump diameters, although the bump diameter is large or small, the via filling property for vias on the substrate is excellent, and heights of formed bumps become uniform. It is considered that this is because the polarization resistance increases.

In the tin or tin alloy electroplating solution according to the second aspect of the present invention, two or more selected from a surfactant other than the surfactant (C), an antioxidant, and an alcohol having 1 to 4 carbon atoms are further contained; and thereby, the following effects are exhibited. The surfactant other than the surfactant (C) exhibits effects such as stabilization of the electroplating solution, improvement of solubility, and the like. In addition, the antioxidant prevents the oxidation of a soluble stannous salt to a stannic salt. Furthermore, the alcohol exhibits an effect of improving the solubility of the surfactant.

The method for forming a bump according to the third aspect of the present invention includes a step of forming tin or tin alloy electroplating deposition layers on a substrate by using the tin or tin alloy electroplating solution, and a step of subsequently performing a reflow process to form bumps. Accordingly, it is possible to form bumps having a uniform height even in a pattern having different bump diameters.

In the method for producing a circuit substrate according to the fourth aspect of the present invention, a circuit substrate is produced by using the bumps formed by the method according to the third aspect. Accordingly, a highly reliable semiconductor device without electrical connection failure can be produced.

### BRIEF DESCRIPTION OF DRAWINGS

FIG. 1(a) is a cross-sectional configuration diagram of a substrate in which an electroplating deposition layer is formed in a via according to the present embodiment. FIG. 1(b) is a cross-sectional configuration diagram of the substrate after peeling a dry film and a copper seed layer and heating the electroplating deposition layer.

FIG. 2(a) is a cross-sectional configuration diagram showing an example in which electroplating deposition layers are uniformly formed in a pattern having different bump diameters (via diameters). FIG. 2(b) is a cross-sectional configuration diagram showing an example in which the electroplating deposition layers are non-uniformly formed in a pattern having different bump diameters (via diameters). FIG. 2(c) is a cross-sectional configuration diagram of a substrate which is in a state after peeling a dry film and a copper seed layer in FIG. 2(a) and heating the electroplating deposition layers, and shows an example in which heights of formed bumps are uniform. FIG. 2(d) is a cross-sectional configuration diagram of a substrate which is in a state after peeling a dry film and a copper seed layer in FIG. 2(b) and heating the electroplating deposition layers, and shows an example in which heights of formed bumps vary.

FIG. 3(a) is a cross-sectional configuration diagram of a substrate in which a tin electroplating deposition layer is formed in a via according to the present embodiment. FIG. 3(b) is a cross-sectional configuration diagram of the substrate after peeling a dry film and a copper seed layer and heating the tin electroplating deposition layer.

### EMBODIMENTS FOR CARRYING OUT THE INVENTION

Subsequently, an embodiment of the present invention will be described with reference to the figures. A tin or tin alloy electroplating solution of the present embodiment contains a soluble salt (A) including at least a stannous salt, one or more compounds (B) selected from the group consisting of an organic acid, an inorganic acid, and a salt thereof, a surfactant (C), and a leveling agent (D). Hereinafter, one or more compounds (B) selected from the group consisting of an organic acid, an inorganic acid, and a salt thereof are also referred to as acids or salts thereof (B).

The soluble salt (A) includes either one of a stannous salt or a mixture of the stannous salt and salts of one or more metals selected from the group consisting of silver, copper, bismuth, nickel, antimony, indium, and zinc.

The tin alloy of the present embodiment is an alloy of tin and one or more of predetermined metals selected from the group consisting of silver, copper, bismuth, nickel, antimony, indium, and zinc, and examples thereof include binary alloys such as a tin-silver alloy, a tin-copper alloy, a tin-bismuth alloy, a tin-nickel alloy, a tin-antimony alloy, a tin-indium alloy, and a tin-zinc alloy, and ternary alloys such as a tin-copper-bismuth alloy and tin-copper-silver alloy.

Therefore, the soluble salt (A) of the present embodiment means any soluble salt that generates various metal ions such as Sn2⁺, Ag⁺, Cu⁺, Cu²⁺, Bi³⁺, Ni²⁺, Sb³⁺, In³⁺, and Zn²⁺ in an electroplating solution. Examples of the soluble salt (A) include oxides and halides of the metals, the metal salts of inorganic acids or organic acids, and the like.

Examples of the oxide of the metal include stannous oxide, copper oxide, nickel oxide, bismuth oxide, antimony oxide, indium oxide, zinc oxide, and the like. Examples of the halides of the metals include stannous chloride, bismuth chloride, bismuth bromide, cuprous chloride, cupric chloride, nickel chloride, antimony chloride, indium chloride, zinc chloride, and the like.

Examples of the metal salt of inorganic acid or organic acid include copper sulfate, stannous sulfate, bismuth sulfate, nickel sulfate, antimony sulfate, bismuth nitrate, silver nitrate, copper nitrate, antimony nitrate, indium nitrate, nickel nitrate, zinc nitrate, copper acetate, nickel acetate, nickel carbonate, sodium stannate, stannous borofluoride, stannous methanesulfonate, silver methanesulfonate, copper methanesulfonate, bismuth methanesulfonate, nickel methanesulfonate, indium methanesulfonate, zinc bis(methanesulfonate), stannous ethanesulfonate, and bismuth 2-hydroxypropanesulfonate.

The acid or a salt thereof (B) of the present embodiment is one or more compounds selected from the group consisting of an organic acid, an inorganic acid, and a salt thereof. Examples of the organic acid include an organic sulfonic acid such as an alkane sulfonic acid, an alkanol sulfonic acid, and an aromatic sulfonic acid, and an aliphatic carboxylic acid. Examples of the inorganic acid include a borofluoric acid, a hydrosilicofluoric acid, a sulfamic acid, a hydrochloric acid, a sulfuric acid, a nitric acid, and a perchloric acid. Examples of the salt thereof include a salt of alkali metal, a salt of alkaline earth metal, an ammonium salt, an amine salt, and a sulfonate. The component (B) is preferably the organic sulfonic acid from a viewpoint of solubility of the metal salt or ease of wastewater treatment.

As the alkane sulfonic acid, a material represented by a chemical formula CₙH₍₂ₙ₊₁₎SO₃H (for example, n = 1 to 5, preferably 1 to 3) can be used. Specific examples thereof include methanesulfonic acid, ethanesulfonic acid, 1-propanesulfonic acid, 2-propanesulfonic acid, 1-butanesulfonic acid, 2-butanesulfonic acid, pentanesulfonic acid, hexanesulfonic acid, decanesulfonic acid, dodecanesulfonic acid, and the like.

As the alkanolsulfonic acid, a material represented by a chemical formula CₚH₍₂ₚ₊₁₎-CH(OH)-C_{q}H_{2q}-SO₃H (for example, p = 0 to 6, q = 1 to 5) can be used. Specific examples thereof include 2-hydroxyethane-1-sulfonic acid, 2-hydroxypropane-1-sulfonic acid, 2-hydroxybutane-1-sulfonic acid, 2-hydroxypentane-1-sulfonic acid, 1-hydroxypropane-2-sulfonic acid, 3 -hydroxypropane-1-sulfonic acid, 4-hydroxybutane-1-sulfonic acid, 2-hydroxyhexane-1-suifonic acid, 2-hydroxydecane-1-suifonic acid, 2-hydroxydodecane-1-sulfonic acid, and the like.

The aromatic sulfonic acid is basically benzenesulfonic acid, alkylbenzenesulfonic acid, phenolsulfonic acid, naphthalenesulfonic acid, alkylnaphthalenesulfonic acid, and the like. Specific examples thereof include 1-naphthalenesulfonic acid, 2-naphthalenesulfonic acid, toluenesulfonic acid, xylenesulfonic acid, p-phenolsulfonic acid, cresolsulfonic acid, sulfosalicylic acid, nitrobenzenesulfonic acid, sulfobenzoic acid, and diphenylamine-4-sulfonic acid.

Examples of the aliphatic carboxylic acid include acetic acid, propionic acid, butyric acid, citric acid, tartaric acid, gluconic acid, sulfosuccinic acid, and trifluoroacetic acid.

The surfactant (C) of the present embodiment is one or more selected from the group consisting of polyoxyethylene polycyclic phenyl ether sulfuric acid ester salts represented by General Formulae (structural formulae) (1), (2), (3), and (4). The term "polycyclic" as used herein means a structure having two or more phenyl groups in the molecule.

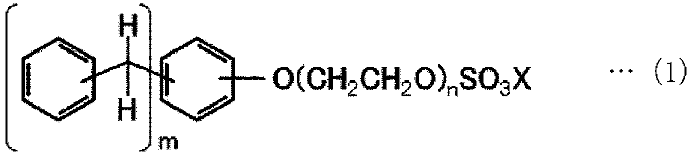

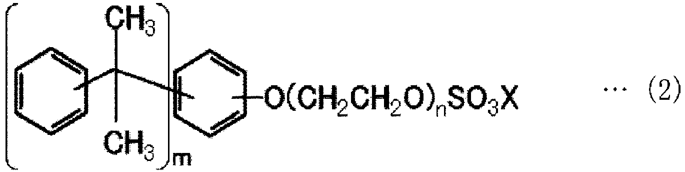

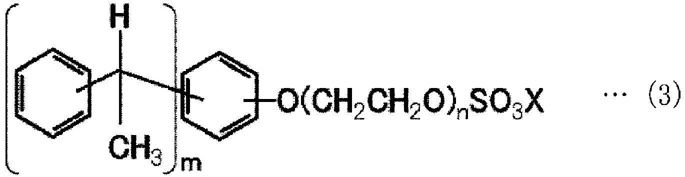

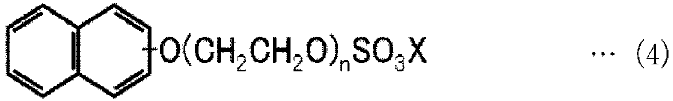

In General Formulae (1), (2), and (3), m is an integer of 1 to 3. In General Formulae (1), (2), (3), and (4), n is an integer of 10 to 30, and X is a cation. m is the number of substituents to be substituted with hydrogen in a benzene ring having an alkoxy group, and the substituents are represented by structural formulae in parentheses. m is a number obtained by subtracting 1 from the number of phenyl groups. That is, the number of phenyl groups in one molecule is (m + 1). n is the number of polyoxyethylene groups. The reason why m is limited to 3 or less is that dissolution to the electroplating solution is difficult in a case where m is 4 or more (the number of phenyl groups is 5 or more). In addition, the reason why n is limited to the range of 10 to 30 is as follows. In a case where n is 9 or less, there is a problem that the appearance of an electroplated film is abnormal. In a case where n is 31 or more, there is a problem that the via filling property is inferior. Furthermore, examples of the cation include Na⁺, NH₄⁺, K⁺, and the like. Furthermore, n is preferably 15 to 25. In the present embodiment, it is also possible to simultaneously use two or more kinds of polyoxyethylene polycyclic phenyl ether sulfuric acid ester salts. For example, it is also possible to simultaneously use two or more polyoxyethylene polycyclic phenyl ether sulfuric acid ester salts having different cations such as Na salt and NH₄ salt.

Specific examples of the polyoxyethylene polycyclic phenyl ether sulfuric acid ester salt represented by General Formula (1) include a compound represented by the following Formula (1-1) in which the number of phenyl groups is 2 (m = 1), a compound represented by the following Formula (1-2) in which the number of phenyl groups is 3 (m = 2), a compound represented by the following Formula (1-3) in which the number of phenyl groups is 4 (m = 3), and the like.

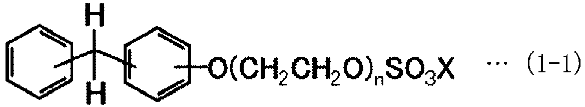

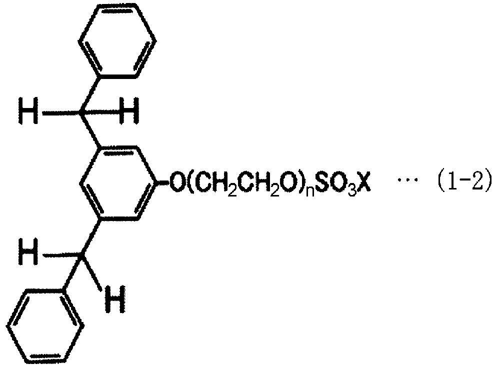

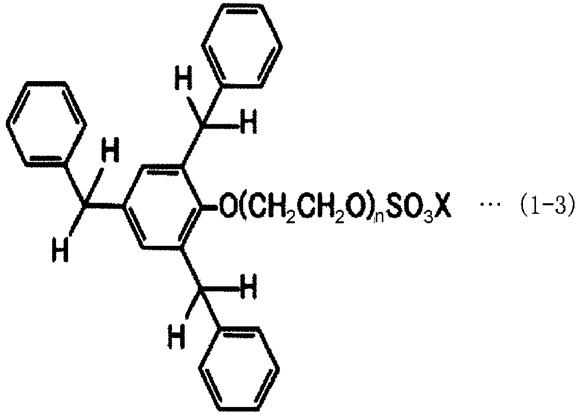

Specific examples of the polyoxyethylene polycyclic phenyl ether sulfuric acid ester salt represented by General Formula (2) include a compound represented by the following Formula (2-1) in which the number of phenyl groups is 2 (m = 1), a compound represented by the following Formula (2-2) in which the number of phenyl groups is 3 (m = 2), a compound represented by the following Formula (2-3) in which the number of phenyl groups is 4 (m = 3), and the like.

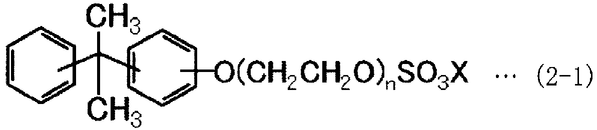

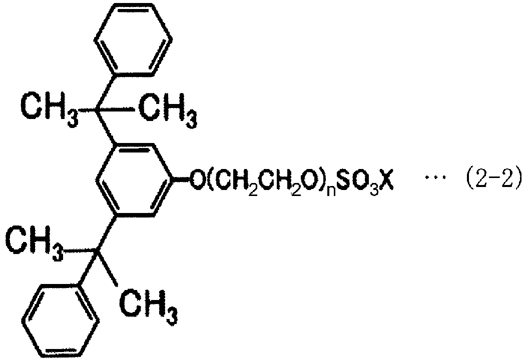

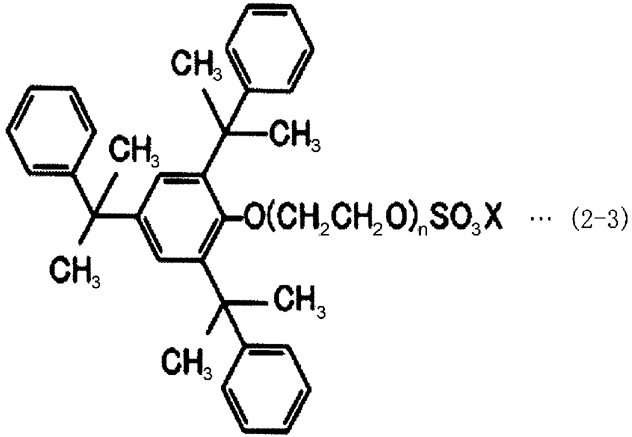

Specific examples of the polyoxyethylene polycyclic phenyl ether sulfuric acid ester salt represented by General Formula (3) include a compound represented by the following Formula (3-1) in which the number of phenyl groups is 2 (m = 1), a compound represented by the following Formula (3-2) in which the number of phenyl groups is 3 (m = 2), a compound represented by the following Formula (3-3) in which the number of phenyl groups is 4 (m = 3), and the like.

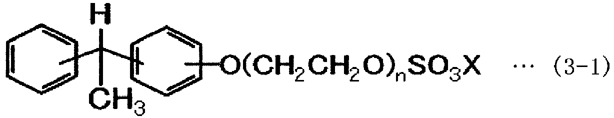

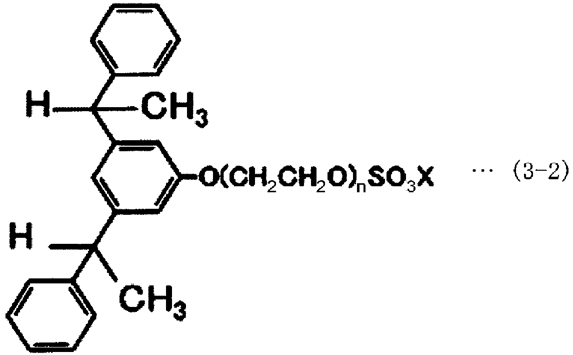

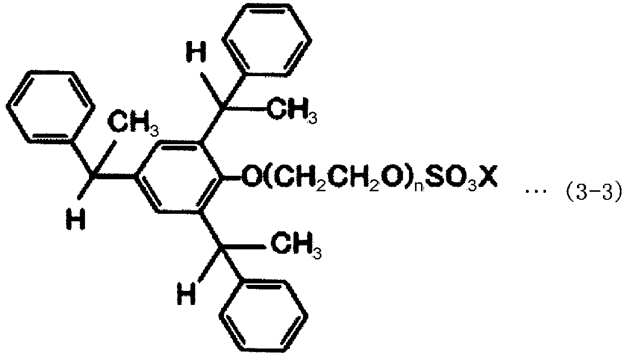

The polyoxyethylene polycyclic phenyl ether sulfuric acid ester salt represented by General Formula (4) has two phenyl groups, and specific examples of a compound having three or more phenyl groups are not described since the compound having three or more phenyl groups is not dissolved in an electroplating solution.

The leveling agent (D) of the present embodiment is added to form a uniform and dense electroplated film and to smooth the electroplated film. In order to improve the via filling property and suppress the generation of voids, two kinds of a first leveling agent (D-1) and a second leveling agent (D-2) are used. Examples of the first leveling agent (D-1) include one or more kinds selected from the group consisting of aliphatic aldehyde, aromatic aldehyde, aliphatic ketone, and aromatic ketone. Examples of the second leveling agent (D-2) include α,β-unsaturated carboxylic acid, amide thereof, and a salt thereof.

The first leveling agent (D-1) is a carbonyl compound containing aldehyde or ketone, and does not include the α, β-unsaturated carboxylic acid of the second leveling agent (D-2). Specific examples of the first leveling agent are as follows. Examples of the aliphatic aldehyde include formaldehyde, acetaldehyde, and allyl aldehyde.
Examples of the aromatic aldehyde include benzaldehyde, 2-chlorobenzaldehyde, 3-chlorobenzaldehyde, 4-chlorobenzaldehyde, 2,4-dichlorobenzaldehyde, 2,6-dichlorobenzaldehyde, 2,4,6-trichlorobenzaldehyde, 1-naphthaldehyde, 2-naphthaldehyde, 2-hydroxybenzaldehyde, 3-hydroxybenzaldehyde, 4-hydroxybenzaldehyde, 2-methylbenzaldehyde, 3-methylbenzaldehyde, 4-methylbenzaldehyde, m-anisaldehyde, o-anisaldehyde, and p-anisaldehyde. In addition, examples of the aliphatic ketone include acetylacetone. Furthermore, examples of the aromatic ketone include benzylideneacetone (synonymous with benzalacetone), 2-chloroacetophenone, 3-chloroacetophenone, 4-chloroacetophenone, 2,4-dichloroacetophenone, and 2,4,6-trichloroacetophenone. One of these may be used alone, or a combination of two or more kinds thereof may be used. A preferred amount of the first leveling agent (D-1) in a plating solution (an amount of a single substance in a case where it is used alone, and a total amount of substances in a case where two or more kinds are included) is 0.001 g/L to 0.3 g/L and more preferably 0.01 g/L to 0.25 g/L. In a case where the amount of the component is small, the effect of adding the component is not sufficient, and on the other hand, in a case where the amount of the component is excessively large, the smoothing of the electroplated film may be inhibited.

Examples of the second leveling agent (D-2) include acrylic acid, methacrylic acid, picolinic acid, crotonic acid, 3-chloroacrylic acid, 3,3-dimethylacrylic acid, 2,3-dimethylacrylic acid, methyl acrylate, ethyl acrylate, n-butyl acrylate, isobutyl acrylate, 2-ethylhexyl acrylate, ethyl methacrylate, n-butyl methacrylate, isobutyl methacrylate, 2-hydroxyethyl methacrylate, 2-hydroxypropyl methacrylate, 2-dimethylaminoethyl methacrylate, methacrylic anhydride, and methyl methacrylic acid. In addition, examples of the second leveling agent (D-2) also include amide of α,β-unsaturated carboxylic acid (for example, acrylamide or the like) and a salt of α,β-unsaturated carboxylic acid (for example, salt of potassium, sodium, or ammonium). A preferred amount of the second leveling agent (D-2) in the plating solution (an amount of a single substance in a case where it is used alone, and a total amount of substances in a case where two or more kinds are included) is 0.01 g/L to 50 g/L and more preferably 0.05 g/L to 10 g/L. In a case where the amount of the component is small, the effect of adding the component is not sufficient, and on the other hand, in a case where the amount of the component is excessively large, the smoothing of the electroplated film may be inhibited.

It is preferable that the tin or tin alloy electroplating solution according to the present embodiment further contains two or more selected from the group consisting of a surfactant (E) other than the surfactant (C), an antioxidant (F), and an alcohol (G) having 1 to 4 carbon atoms.

In this case, examples of the surfactant (E) other than the surfactant (C) include an anionic surfactant, a cationic surfactant, a nonionic surfactant, and an amphoteric surfactant.

Examples of the anionic surfactant (E-1) include polyoxyalkylene alkyl ether sulfate such as sodium polyoxyethylene (containing 12 mol of ethylene oxide) nonyl ether sulfate; polyoxyalkylene alkyl phenyl ether sulfate such as sodium polyoxyethylene (containing 12 mol of ethylene oxide) dodecylphenyl ether sulfate; alkyl benzene sulfonate such as sodium dodecylbenzene sulfonate; naphthol sulfonate such as sodium 1-naphthol-4-sulfonate and disodium 2-naphthol-3,6-disulfonate; (poly)alkylnaphthalenesulfonate such as sodium diisopropylnaphthalenesulfonate and sodium dibutylnaphthalenesulfonate; and alkyl sulfate such as sodium dodecyl sulfate and sodium oleyl sulfate.

Examples of the cationic surfactant (E-2) include monoalkylamine salt, dialkylamine salt, trialkylamine salt, dimethyldialkylammonium salt, trimethylalkylammonium salt, dodecyltrimethylammonium salt, hexadecyltrimethylammonium salt, octadecyltrimethylammonium salt, dodecyldimethylammonium salt, octadecenyldimethylethylammonium salt, dodecyldimethylbenzylammonium salt, hexadecyldimethylbenzylammonium salt, octadecyldimethylbenzylammonium salt, trimethylbenzylammonium salt, triethylbenzylammonium salt, hexadecylpyridinium salt, dodecylpyridinium salt, dodecylpicolinium salt, dodecylimidazolinium salt, oleylimidazolinium salt, octadecylamine acetate, and dodecylamine acetate.

Examples of the nonionic surfactant (E-3) include sugar ester, fatty acid ester, C₁ to C₂₅ alkoxyl phosphoric acid (salt), sorbitan ester, silicon-based polyoxyethylene ether, silicon-based polyoxyethylene ester, fluorine-based polyoxyethylene ether, fluorine-based polyoxyethylene ester, a sulfated or sulfonated adduct of a condensation product of ethylene oxide and/or propylene oxide and either one of alkylamine or diamine, and polyoxyethylene cumyl phenyl ether (where, 10 to 14 EO chain).

Examples of the amphoteric surfactant (E-4) include betaine, carboxybetaine, imidazolinium betaine, sulfobetaine, and aminocarboxylic acid.

The antioxidant (F) is used for preventing the oxidation of the soluble stannous salt to the stannic salt. Examples of antioxidant include hypophosphorous acids, ascorbic acid, a salt thereof, phenolsulfonic acid (Na), cresolsulfonic acid (Na), hydroquinonesulfonic acid (Na), hydroquinone, α- or β-naphthol, catechol, resorcin, phloroglucin, hydrazine, phenolsulfonic acid, catecholsulfonic acid, hydroxybenzenesulfonic acid, naphtholsulfonic acid, and salts thereof.

Examples of the alcohol (G) having 1 to 4 carbon atoms include methanol, ethanol, 1-propanol, 2-propanol, 2-butanol, and the like. One of the alcohol (G) can be used alone, or a combination of two or more kinds thereof may be used. In a case where an alcohol having 5 or more carbon atoms is used, dissolution to the electroplating solution is difficult. Therefore, an alcohol having 1 to 4 carbon atoms is preferably used.

The amount of the surfactant (C) in the electroplating solution according to the present embodiment is 0.5 g/L to 50 g/L and preferably 2 g/L to 20 g/L. In a case where the amount is less than the lower limit or more than the upper limit, electroplating failure such as a dendrite may occur due to an excessive supply of Sn ions.

One of the predetermined soluble metal salt (A) can be used alone, or a combination of two or more kinds thereof may be used. The amount of the soluble metal salt (A) in the electroplating solution is 15 g/L to 100 g/L and preferably 20 g/L to 50 g/L. In a case where the amount is less than the appropriate range, the productivity is reduced, and in a case where the amount increases, the cost of the electroplating solution may increase.

One of the inorganic acid, organic acid, or salt thereof (B) can be used alone, or a combination of two or more kinds thereof may be used. The amount of the inorganic acid, organic acid, or salt thereof (B) in the electroplating solution is 80 g/L to 300 g/L and preferably 100 g/L to 200 g/L. In a case where the amount is less than the appropriate range, electrical conductivity may be low and voltage may rise. In a case where the amount increases, viscosity of the electroplating solution may increase, and stirring speed of the electroplating solution may decrease.

In a case where the surfactant (E) different from the surfactant (C) is contained, the amount of the surfactant (E) is preferably 2 g/L to 20 g/L.

In a case where the antioxidant (F) is contained, the amount of the antioxidant (F) is preferably 0.1 g/L to 5 g/L.

In a case where the alcohol (G) having 1 to 4 carbon atoms is contained, the amount of the alcohol (G) having 1 to 4 carbon atoms is preferably 10 g/L to 30 g/L.

Next, a method for forming bumps using the plating solution of the present embodiment will be described with reference to FIG. 1. First, as shown in FIG. 1(a), a solder resist layer 2 having an opening on a surface of a substrate 1 is formed. A copper seed layer 3 for supplying electricity is formed on a surface of the solder resist layer 2. A dry film resist layer 4 is formed on a surface of the copper seed layer 3. Subsequently, a dry film resist pattern having an opening is formed to be connected to the opening of the solder resist layer 2. Subsequently, by supplying electricity through the copper seed layer 3, tin electroplating is performed in a via 6 of the dry film resist pattern, and a tin plating deposition layer 7 (tin plated film) is formed in the via 6 on the copper seed layer 3. The solution temperature during the formation of the plated film of the tin electroplating solution is generally 70°C or lower and preferably 10°C to 40°C. A current density during the formation of the plated film by tin electroplating is in a range of 0.1 A/dm² to 100 A/dm² and preferably in a range of 0.5 A/dm² to 20 A/dm². In a case where the current density is too low, the productivity may deteriorate, and in a case where the current density is too high, the appearance of the plating deposition layer may deteriorate. Furthermore, the dry film resist layer 4 and the copper seed layer 3 are sequentially removed. Subsequently, the remaining tin plating deposition layer 7 is melted by a reflow process, and a tin bump 8 is formed as shown in FIG. 1(b). In a case where bumps are formed by this method, since the plating solution of the present embodiment is used, it is possible to form the tin plating deposition layer 7 uniformly and densely and to smooth the tin plating deposition layer 7. As a result, it is possible to improve the via filling property and suppress the occurrence of voids.

Subsequently, a method for forming bumps using the plating solution of the present embodiment, which is different from the above-described method, will be described with reference to FIG. 3. First, as shown in FIG. 3(a), a solder resist layer 12 having an opening is formed on a surface of a substrate 11 on which wiring or the like is provided. A copper seed layer for supplying electricity is formed on a surface of the solder resist layer 12 by electroless plating. Subsequently, electricity is supplied through this copper seed layer to perform copper electroplating inside a via of the solder resist layer 12; and thereby, a copper plated layer 13 is formed. Thereafter, a surface of this copper plated layer 13 and the surface of the solder resist layer 12 are flattened. Subsequently, an electroless copper seed layer 14 for supplying electricity is formed on the surface of the solder resist layer 12 and the surface of the copper plated layer 13. A dry film resist pattern (dry film resist layer 15) having an opening is formed on a surface of the electroless copper seed layer 14. Subsequently, electricity is supplied through the electroless copper seed layer 14 to form a nickel plated layer 17 on an inner bottom portion of a via 16 of the dry film resist pattern. Subsequently, a tin plating deposition layer 18 (tin plated film) is formed on the nickel plated layer 17. Furthermore, the dry film resist layer 15 and the electroless copper seed layer 14 are sequentially removed. Subsequently, the remaining tin plating deposition layer 18 is melted by a reflow process, and a tin bump 19 is formed as shown in FIG. 3(b). Even though bumps are formed by this method, since the plating solution of the present embodiment is used, it is possible to form the tin plating deposition layer 18 uniformly and densely and to smooth the tin plating deposition layer 18. As a result, it is possible to improve the via filling property and suppress the occurrence of voids.

When a tin or tin alloy electroplating solution containing the surfactant (C) of the present embodiment as a surfactant is applied to a circuit substrate which is an object to be plated, it is possible to form a predetermined metal film on this circuit substrate. Examples of the circuit substrate include a printed circuit substrate, a flexible printed circuit substrate, and a semiconductor integrated circuit substrate.

The tin or tin alloy plating solution of the present embodiment can be suitably used for forming a tin or tin alloy plating deposition layer on a substrate in which vias having a plurality of types of via diameters are present. In this case, the tin or tin alloy plating deposition layer can be formed uniformly and densely, and the tin or tin alloy plating deposition layer can be smoothed; and as a result, it is possible to improve the via filling property and suppress the occurrence of voids. Then, the height uniformity of the bumps obtained by reflowing the tin or tin alloy plating deposition layer can be improved.

### EXAMPLES

Next, Examples of the present embodiment will be described in detail together with Comparative Examples.

### (Surfactant (C) used in Examples and Comparative Examples)

Each of the number of m and the number of n in each structural formula of the surfactant (C) used in Examples and Comparative Examples was determined by liquid chromatography-mass spectrometry (LC/MS).

<Example 1>

### (Preparation of Electrolytic Bath of Sn Electroplating Solution)

Potassium methanesulfonic acid as a free acid (B), hydroquinone as the antioxidant (F), benzalacetone as the leveling agent (D-1), methacrylic acid as the leveling agent (D-2), isopropyl alcohol, the surfactant (C), and ion-exchanged water were added to a Sn methanesulfonate aqueous solution to prepare a Sn electroplating solution having the following composition. As the surfactant (C), a polyoxyethylene polycyclic phenyl ether sulfuric acid ester salt in which m in General Formula (1) was 1, that is, the polyoxyethylene polycyclic phenyl ether sulfuric acid ester salt represented by General Formula (1-1) was used, and in the polyoxyethylene polycyclic phenyl ether sulfuric acid ester salt, n was 10, cations were Na⁺ and NH⁴⁺, and a mass-average molecular weight was 730. The Sn methanesulfonate aqueous solution was prepared by electrolyzing a metal Sn plate in a methanesulfonic acid aqueous solution.

### (Composition of Sn Electroplating Solution)

Sn methanesulfonate (as Sn²⁺): 50 g/L
Potassium methanesulfonate (as free acid (B)): 100 g/L
Surfactant (polyoxyethylene polycyclic phenyl ether sulfuric acid ester salt in which n: 10 and cation: Na⁺ and NH⁴⁺ in General Formula (1-1), and mass-average molecular weight: 730): 2 g/L
Hydroquinone (as antioxidant (F)): 1 g/L
Methacrylic acid (as leveling agent (D-2)): 2 g/L
Benzalacetone (as leveling agent (D-1)): 0.1 g/L
Isopropyl alcohol: 10 g/L
Ion-exchanged water: balance

### <Examples 2 to 12 and Comparative Examples 1 to 8>

In Examples 2 to 12 and Comparative Examples 1 to 8, Sn electroplating solutions each were prepared in the same manner as in Example 1, except that compounds shown in Table 1 were blended as the surfactant (C). Specifically, as the surfactant (C) contained in the Sn electroplating solution of each of Examples 1 to 12 and Comparative Examples 1 to 8, the polyoxyethylene polycyclic phenyl ether sulfuric acid ester salt that was represented by any one of General Formulae (1-1), (2-1), (3-1), or (4) was used, and the compound represented by General Formulae (1-1), (2-1), or (3-1) was the compound represented by General Formulae (1), (2), or (3) in which m was 1, and the polyoxyethylene polycyclic phenyl ether sulfuric acid ester salt having the number n of polyoxyethylene (EO) groups and a cation type shown in Table 1 was used to prepare the Sn electroplating solution. In Example 3 and Comparative Example 2, Ag was contained as a metal other than Sn (1.0 g/L of Ag⁺). In Example 11 and Comparative Example 8, Cu was contained as a metal other than Sn (0.5 g/L of Cu²⁺).

### <Comparative Example 9>

A Sn electroplating solution was prepared by in the same manner as in Example 1, except that polyoxyethylene laurylamine (amine-based nonionic surfactant) was used as a surfactant contained in the Sn electroplating solution. This Sn electroplating solution was designated as Comparative Example 9.

### <Comparative Example 10>

A Sn electroplating solution was prepared in the same manner as in Example 1, except that polyoxyethylene stearylamine (amine-based nonionic surfactant) was used as a surfactant contained in the Sn electroplating solution. This Sn electroplating solution was designated as Comparative Example 10.

**Table 1**

| | Polyoxyethylene polycyclic phenyl ether sulfuric acid ester salt (surfactant) | | | | | Metal other than Sn | Evaluation | | | |
|---|---|---|---|---|---|---|---|---|---|---|
| | General Formula | | | | Mass-average molecular weight | | Via filling property | Appearance of electroplating deposition layer | Height variation σ | Void |
| | No. | m | n | Cation | | | | | | |
| Example 1 | (1-1) | 1 | 10 | Na⁺, NH₄⁺ | 730 | - | Good | Good | 2.4 | OK |
| Example 2 | (1-1) | 1 | 20 | Na⁺, NH₄⁺ | 1170 | - | Good | Good | 1.8 | OK |
| Example 3 | (1-1) | 1 | 30 | Na⁺, NH₄⁺ | 1610 | Ag | Good | Good | 2.0 | OK |
| Example 4 | (2-1) | 1 | 10 | Na⁺, NH₄⁺ | 760 | - | Good | Good | 2.1 | OK |
| Example 5 | (2-1) | 1 | 20 | Na⁺, NH₄⁺ | 980 | - | Good | Good | 1.1 | OK |
| Example 6 | (2-1) | 1 | 30 | Na⁺, NH₄⁺ | 1420 | - | Good | Good | 1.7 | OK |
| Example 7 | (3-1) | 1 | 10 | Na⁺, NH₄⁺ | 740 | - | Good | Good | 1.4 | OK |
| Example 8 | (3-1) | 1 | 20 | Na⁺, NH₄⁺ | 1180 | - | Good | Good | 1.5 | OK |
| Example 9 | (3-1) | 1 | 30 | Na⁺, NH₄⁺ | 1620 | - | Good | Good | 2.6 | OK |
| Example 10 | (4) | - | 10 | Na⁺, NH₄⁺ | 710 | - | Good | Good | 2.1 | OK |
| Example 11 | (4) | - | 20 | Na⁺, NH₄⁺ | 1150 | Cu | Good | Good | 2.6 | OK |
| Example 12 | (4) | - | 30 | Na⁺, NH₄⁺ | 1590 | - | Good | Good | 1.9 | OK |

| Table 1 (Continued) | | | | | | | | | | |
|---|---|---|---|---|---|---|---|---|---|---|
| | Polyoxyethylene polycyclic phenyl ether sulfuric acid ester salt (surfactant) | | | | | Metal other than Sn | Evaluation | | | |
| | General Formula | | | | Mass-average molecular weight | | Via filling property | Appearance of electroplating deposition layer | Height variation σ | Void |
| | No. | m | n | Cation | | | | | | |
| Comparative Example 1 | (1-1) | 1 | 9 | Na⁺, NH₄⁺ | 690 | - | Poor | Poor | 3.5 | NG |
| Comparative Example 2 | (1-1) | 1 | 31 | Na⁺, NH₄⁺ | 1660 | Ag | Poor | Poor | 4.0 | NG |
| Comparative Example 3 | (2-1) | 1 | 9 | Na⁺, NH₄⁺ | 720 | - | Poor | Poor | 3.1 | NG |
| Comparative Example 4 | (2-1) | 1 | 31 | Na⁺, NH₄⁺ | 2080 | - | Poor | Poor | 3.8 | NG |
| Comparative Example 5 | (3-1) | 1 | 9 | Na⁺, NH₄⁺ | 700 | - | Poor | Poor | 4.4 | NG |
| Comparative Example 6 | (3-1) | 1 | 31 | Na⁺, NH₄⁺ | 1670 | - | Poor | Poor | 4.5 | NG |
| Comparative Example 7 | (4) | - | 9 | Na⁺, NH₄⁺ | 660 | - | Poor | Poor | 3.8 | NG |
| Comparative Example 8 | (4) | - | 31 | Na⁺, NH₄⁺ | 1630 | Cu | Poor | Poor | 4.0 | NG |
| Comparative Example 9 | Polyoxyethylene laurylamine (amine-based nonionic surfactant) | | | | | - | Poor | Poor | 5.1 | NG |
| Comparative Example 10 | Polyoxyethylene stearylamine (amine-based nonionic surfactant) | | | | | - | Poor | Poor | 4.7 | NG |

### <Examples 13 to 21 and Comparative Examples 11 to 16>

In Examples 13 to 21 and Comparative Examples 11 to 16, Sn electroplating solutions each were prepared in the same manner as in Example 1, except that compounds shown in Table 2 were blended as the surfactant (C). Specifically, as the surfactant (C) contained in the Sn electroplating solution of each of Examples 13 to 21 and Comparative Examples 11 to 16, the polyoxyethylene polycyclic phenyl ether sulfuric acid ester salt represented by any one of General Formulae (1-2), (2-2), or (3-2) was used, and the compound represented by General Formulae (1-2), (2-2), or (3-2) was the compound represented by General Formulae (1), (2), or (3) in which m was 2, and the polyoxyethylene polycyclic phenyl ether sulfuric acid ester salt having the number n of polyoxyethylene (EO) groups and a cation type shown in Table 2 was used to prepare the Sn electroplating solution. In Example 16 and Comparative Example 14, Ag was contained as a metal other than Sn (1.0 g/L of Ag⁺). In Example 20 and Comparative Example 15, Cu was contained as a metal other than Sn (0.5 g/L of Cu²⁺).

**Table 2**

| | Polyoxyethylene polycyclic phenyl ether sulfuric acid ester salt (surfactant) | | | | | Metal other than Sn | Evaluation | | | |
|---|---|---|---|---|---|---|---|---|---|---|
| | General Formula | | | | Mass-average molecular weight | | Via filling property | Appearance of electroplating deposition layer | Height variation σ | Void |
| | No. | m | n | Cation | | | | | | |
| Example 13 | (1-2) | 2 | 10 | Na⁺, NH₄⁺ | 820 | - | Good | Good | 2.2 | OK |
| Example 14 | (1-2) | 2 | 20 | Ma⁺, NH₄⁺ | 1260 | - | Good | Good | 1.7 | OK |
| Example 15 | (1-2) | 2 | 30 | Na⁺, NH₄⁺ | 1700 | - | Good | Good | 1.9 | OK |
| Example 16 | (2-2) | 2 | 10 | Ma⁺, NH₄⁺ | 880 | Ag | Good | Good | 1.8 | OK |
| Example 17 | (2-2) | 2 | 20 | Na⁺, NH₄⁺ | 1100 | - | Good | Good | 1.3 | OK |
| Example 18 | (2-2) | 2 | 30 | Ma⁺, NH₄⁺ | 1540 | - | Good | Good | 1.7 | OK |
| Example 19 | (3-2) | 2 | 10 | Na⁺, NH₄⁺ | 850 | - | Good | Good | 1.8 | OK |
| Example 20 | (3-2) | 2 | 20 | Na⁺, NH₄⁺ | 1290 | Cu | Good | Good | 1.3 | OK |
| Example 21 | (3-2) | 2 | 30 | Ma⁺, NH₄⁺ | 1730 | - | Good | Good | 1.8 | OK |
| Comparative Example 11 | (1-2) | 2 | 9 | Na⁺, NH₄⁺ | 780 | - | Poor | Poor | 4.0 | NG |
| Comparative Example 12 | (1-2) | 2 | 31 | Na⁺, NH₄⁺ | 1750 | - | Poor | Poor | 4.0 | NG |
| Comparative Example 13 | (2-2) | 2 | 9 | Na⁺, NH₄⁺ | 830 | - | Poor | Poor | 3.8 | NG |
| Comparative Example 14 | (2-2) | 2 | 31 | Na⁺, NH₄⁺ | 2200 | Ag | Poor | Poor | 3.4 | NG |
| Comparative Example 15 | (3-2) | 2 | 9 | Na⁺, NH₄⁺ | 800 | Cu | Poor | Poor | 3.9 | NG |
| Comparative Example 16 | (3-2) | 2 | 31 | Na⁺, NH₄⁺ | 1770 | - | Poor | Poor | 4.7 | NG |

### <Examples 22 to 30 and Comparative Examples 17 to 22>

In Examples 22 to 30 and Comparative Examples 17 to 22, Sn electroplating solutions each were prepared in the same manner as in Example 1, except that compounds shown in Table 3 were blended as the surfactant (C). Specifically, as the surfactant (C) contained in the Sn electroplating solution of each of Examples 22 to 30 and Comparative Examples 17 to 22, the polyoxyethylene polycyclic phenyl ether sulfuric acid ester salt represented by any one of General Formulae (1-3), (2-3), or (3-3) was used, and the compound represented by General Formulae (1-3), (2-3), or (3-3) was the compound represented by General Formulae (1), (2), or (3) in which m was 3, and the polyoxyethylene polycyclic phenyl ether sulfuric acid ester salt having the number n of polyoxyethylene (EO) groups and a cation type shown in Table 3 was used to prepare the Sn electroplating solution. In Example 29 and Comparative Example 22, Ag was contained as a metal other than Sn (1.0 g/L of Ag⁺). In Example 26 and Comparative Example 20, Cu was contained as a metal other than Sn (0.5 g/L of Cu²⁺).

**Table 3**

| | Polyoxyethylene polycyclic phenyl ether sulfuric acid ester salt (surfactant) | | | | | Metal other than Sn | Evaluation | | | |
|---|---|---|---|---|---|---|---|---|---|---|
| | General Formula | | | | Mass-average molecular weight | | Via filling property | Appearance of electroplating deposition layer | Height variation | Void |
| | No. | m | n | Cation | | | | | | |
| Example 22 | (1-3) | 3 | 10 | Na⁺, NH₄⁺ | 910 | - | Good | Good | 2.5 | OK |
| Example 23 | (1-3) | 3 | 2C | Na⁺, NH₄⁺ | 1350 | - | Good | Good | 1.4 | OK |
| Example 24 | (1-3) | 3 | 3C | Na⁺, NH₄⁺ | 1790 | - | Good | Good | 1.3 | OK |
| Example 25 | (2-3) | 3 | 10 | Na⁺, NH₄⁺ | 1000 | - | Good | Good | 2.2 | OK |
| Example 26 | (2-3) | 3 | 20 | Na⁺, NH₄⁺ | 1220 | Cu | Good | Good | 1.0 | OK |
| Example 27 | (2-3) | 3 | 30 | Na⁺, NH₄⁺ | 1660 | - | Good | Good | 1.4 | OK |
| Example 28 | (3-3) | 3 | 10 | Na⁺, NH₄⁺ | 950 | - | Good | Good | 1.9 | OK |
| Example 29 | (3-3) | 3 | 20 | Na⁺, NH₄⁺ | 1390 | Ag | Good | Good | 1.2 | OK |
| Example 30 | (3-3) | 3 | 30 | Na⁺, NH₄⁺ | 1830 | - | Good | Good | 2.8 | OK |
| Comparative Example 17 | (1-3) | 3 | 9 | Na⁺, NH₄⁺ | 870 | - | Poor | Poor | 3.4 | NG |
| Comparative Example 18 | (1-3) | 3 | 31 | Na⁺, NH₄⁺ | 1840 | - | Poor | Poor | 3.7 | NG |
| Comparative Example 19 | (2-3) | 3 | 9 | Na⁺, NH₄⁺ | 950 | - | Poor | Poor | 3.8 | NG |
| Comparative Example 20 | (2-3) | 3 | 31 | Na⁺, NH₄⁺ | 2320 | Cu | Poor | Poor | 3.1 | NG |
| Comparative Example 21 | (3-3) | 3 | 9 | Na⁺, NH₄⁺ | 910 | - | Poor | Poor | 4.5 | NG |
| Comparative Example 22 | (3-3) | 3 | 31 | Na⁺, NH₄⁺ | 1870 | Ag | Poor | Poor | 4.6 | NG |

### <Comparative Test 1 and Evaluation>

The 52 kinds of electroplating solutions prepared in Examples 1 to 30 and Comparative Examples 1 to 22 were used to form bumps. The via filling property of the tin or tin alloy electroplating deposition layer in the vias until the bumps were formed, the appearance of the bumps after the bump formation, and the variation in bump height (uniformity) were evaluated. Tables 1 to 3 show the results thereof.

### (1) Via Filling Property of Tin or Tin Alloy Electroplating Deposition Layer in Via

The tin or tin alloy electroplating deposition layers in 100 vias were observed with a laser microscope, and a difference in height between the highest point and the lowest point of the electroplating deposition layer was measured. A case where there was even one via in which the difference in height was more than 5 µm was determined as "poor", other cases were determined as "good", and these were shown in the column of "Via filling property" in Tables 1 to 3.

### (2) Appearance of Tin or Tin Alloy Electroplating Deposition Layer in Via

The tin or tin alloy electroplating deposition layers in 100 vias were observed with a laser microscope, and a surface roughness Ra was measured. A case where there was even one via in which the surface roughness Ra of the electroplating deposition layer was more than 2 µm was determined as "poor", other cases were determined as "good", and these were shown in the column of "Appearance of electroplating deposition layer" in Tables 1 to 3.

### (3) Variation in Bump Height

The heights of bumps on the substrate were measured using an automatic appearance inspection device. The number of measured pieces was 10,000. A height variation σ was calculated from the measured bump heights. The height of the bump was the distance from a surface of the solder resist layer to the bump apex (highest point). A case where the height variation σ was 3 or less was determined as "uniform", and a case where the height variation σ was more than 3 was determined as "non-uniform". The results (values of height variation σ) are shown in the column of "Bump height variation" in Tables 1 to 3.

### (4) Tendency of Occurrence of Void

X-ray transmission images of bumps (2000 bumps in total) arranged at pitch intervals of 100 µm, 180 µm, 250 µm, and 360 µm and having diameters of 40 µm, 70 µm, 90 µm, and 120 µm were photographed. The photographed images were visually observed. A case where one or more bumps including voids having a size of 1% or more with respect to the size of the bump were observed was determined as "NG", and other cases were determined as "OK". The results thereof were shown in the column of "Void" in Tables 1 to 3.

As is clear from Table 1, although the surfactant (C) of Comparative Example 1 was represented by General Formula (1-1), and m was 1 which was within the appropriate range (m = 1 to 3), n was 9 which was smaller than the appropriate range (n = 10 to 30). In Comparative Example 1, both the filling property and the appearance of the bumps were poor, the height variation σ of the bumps was 3.5 which was large, and furthermore voids were observed in the bumps.

Although the surfactant (C) of Comparative Example 2 was represented by General Formula (1-1), and m was 1 which was within the appropriate range (m = 1 to 3), n was 31 which was greater than the appropriate range (n = 10 to 30). The electroplating solution of tin alloy contained silver. In Comparative Example 2, both the filling property and the appearance of the bumps were poor, the height variation σ of the bumps was 4.0 which was large, and furthermore voids were observed in the bumps.

In contrast, the surfactants (C) of Examples 1 and 2 each were represented by General Formula (1-1), m was 1 which was within the appropriate range (m = 1 to 3), and n was 10 and 20, respectively, which was within the appropriate range (n = 10 to 30). In Examples 1 and 2, both the filling property and the appearance of the bumps were good, the height variation σ of the bumps was 2.4 and 1.8, respectively which was small, and furthermore no voids were observed in the bumps.

The surfactant (C) of Example 3 was represented by General Formula (1-1), m was 1 which was within the appropriate range (m = 1 to 3), and n was 30 which was within the appropriate range (n = 10 to 30). The electroplating solution of tin alloy contained silver. In Example 3, both the filling property and the appearance of the bumps were good, the height variation σ of the bumps was 2.0 which was small, and furthermore no voids were observed in the bumps.

On the other hand, although the surfactant (C) of Comparative Example 3 was represented by General Formula (2-1) and m was 1 which was within the appropriate range (m = 1 to 3), n was 9 which was smaller than the appropriate range (n = 10 to 30). In Comparative Example 3, both the filling property and the appearance of the bumps were poor, the height variation σ of the bumps was 3.1 which was large, and furthermore voids were observed in the bumps.

Although the surfactant (C) of Comparative Example 4 was represented by General Formula (2-1) and m was 1 which was within the appropriate range (m = 1 to 3), n was 31 which was greater than the appropriate range (n = 10 to 30). In Comparative Example 4, both the filling property and the appearance of the bumps were poor, the height variation σ of the bumps was 3.8 which was large, and furthermore voids were observed in the bumps.

In contrast, the surfactants (C) of Examples 4 to 6 each were represented by General Formula (2-1), m was 1 which was within the appropriate range (m = 1 to 3), and n was 10, 20, and 30, respectively, which was within the appropriate range (n = 10 to 30). In each of Examples 4 to 6, both the filling property and the appearance of the bumps were good, the height variation σ of the bumps was 1.1 to 2.1 which was small, and furthermore no voids were observed in the bumps.

On the other hand, although the surfactant (C) of Comparative Example 5 was represented by General Formula (3-1) and m was 1 which was within the appropriate range (m = 1 to 3), n was 9 which was smaller than the appropriate range (n = 10 to 30). In Comparative Example 5, both the filling property and the appearance of the bumps were poor, the height variation σ of the bumps was 4.4 which was large, and furthermore voids were observed in the bumps.

Although the surfactant (C) of Comparative Example 6 was represented by General Formula (3-1) and m was 1 which was within the appropriate range (m = 1 to 3), n was 31 which was greater than the appropriate range (n = 10 to 30). In Comparative Example 6, both the filling property and the appearance of the bumps were poor, the height variation σ of the bumps was 4.5 which was large, and furthermore voids were observed in the bumps.

In contrast, the surfactants (C) of Examples 7 to 9 each were represented by General Formula (3-1), m was 1 which was within the appropriate range (m = 1 to 3), and n was 10, 20, and 30, respectively, which was within the appropriate range (n = 10 to 30). In each of Examples 7 to 9, both the filling property and the appearance of the bumps were good, the height variation σ of the bumps was 1.4 to 2.6 which was small, and furthermore no voids were observed in the bumps.

On the other hand, the surfactant (C) of Comparative Example 7 was represented by General Formula (4), and n was 9 which was smaller than the appropriate range (n = 10 to 30). In Comparative Example 7, both the filling property and the appearance of the bumps were poor, the height variation σ of the bumps was 3.8 which was large, and furthermore voids were observed in the bumps.

The surfactant (C) of Comparative Example 8 was represented by General Formula (4), and n was 31 which was greater than the appropriate range (n = 10 to 30). The electroplating solution of tin alloy contained copper. In Comparative Example 8, both the filling property and the appearance of the bumps were poor, the height variation σ of the bumps was 4.0 which was large, and furthermore voids were observed in the bumps.

In contrast, the surfactants (C) of Examples 10 and 12 each were represented by General Formula (4), and n was 10 and 30, respectively, which was within the appropriate range (n = 10 to 30). In Examples 10 and 12, both the filling property and the appearance of the bumps were good, the height variation σ of the bumps was 2.1 and 1.9, respectively which was small, and furthermore no voids were observed in the bumps.

The surfactant (C) of Example 11 was represented by General Formula (4), and n was 20 which was within the appropriate range (n = 10 to 30). The electroplating solution of tin alloy contained copper. In Example 11, both the filling property and the appearance of the bumps were good, the height variation σ of the bumps was 2.6 which was small, and furthermore no voids were observed in the bumps.

In Comparative Example 9, polyoxyethylene laurylamine (amine-based nonionic surfactant) was used as the surfactant. In Comparative Example 9, both the filling property and the appearance of the bumps were poor, the height variation σ of the bumps was 5.1 which was large, and furthermore voids were observed in the bumps.

In Comparative Example 10, polyoxyethylene stearylamine (amine-based nonionic surfactant) was used as the surfactant. In Comparative Example 10, both the filling property and the appearance of the bumps were poor, the height variation σ of the bumps was 4.7 which was large, and furthermore voids were observed in the bumps.

As is clear from Table 2, although the surfactant (C) of Comparative Example 11 was represented by General Formula (1-2) and m was 2 which was within the appropriate range (m = 1 to 3), n was 9 which was smaller than the appropriate range (n = 10 to 30). In Comparative Example 11, both the filling property and the appearance of the bumps were poor, the height variation σ of the bumps was 4.0 which was large, and furthermore voids were observed in the bumps.

Although the surfactant (C) of Comparative Example 12 was represented by General Formula (1-2) and m was 2 which was within the appropriate range (m = 1 to 3), n was 31 which was greater than the appropriate range (n = 10 to 30). In Comparative Example 12, both the filling property and the appearance of the bumps were poor, the height variation σ of the bumps was 4.0 which was large, and furthermore voids were observed in the bumps.

In contrast, the surfactants (C) of Examples 13 to 15 each were represented by General Formula (1-2), m was 2 which was within the appropriate range (m = 1 to 3), and n was 10, 20, and 30, respectively, which was within the appropriate range (n = 10 to 30). In each of Examples 13 to 15, both the filling property and the appearance of the bumps were good, the height variation σ of the bumps was 1.7 to 2.2 which was small, and furthermore no voids were observed in the bumps.

On the other hand, although the surfactant (C) of Comparative Example 13 was represented by General Formula (2-2) and m was 2 which was within the appropriate range (m = 1 to 3), n was 9 which was smaller than the appropriate range (n = 10 to 30). In Comparative Example 13, both the filling property and the appearance of the bumps were poor, the height variation σ of the bumps was 3.8 which was large, and furthermore voids were observed in the bumps.

Although the surfactant (C) of Comparative Example 14 was represented by General Formula (2-2) and m was 2 which was within the appropriate range (m = 1 to 3), n was 31 which was greater than the appropriate range (n = 10 to 30). The electroplating solution of tin alloy contained silver. In Comparative Example 14, both the filling property and the appearance of the bumps were poor, the height variation σ of the bumps was 3.4 which was large, and furthermore voids were observed in the bumps.

In contrast, the surfactant (C) of Example 16 was represented by General Formula (2-2), m was 2 which was within the appropriate range (m = 1 to 3), and n was 10 which was within the appropriate range (n = 10 to 30). The electroplating solution of tin alloy contained silver. In Example 16, both the filling property and the appearance of the bumps were good, the height variation σ of the bumps was 1.8 which was small, and furthermore no voids were observed in the bumps.

The surfactants (C) of Examples 17 and 18 each were represented by General Formula (2-2), m was 2 which was within the appropriate range (m = 1 to 3), and n was 20 and 30, respectively, which was within the appropriate range (n = 10 to 30). In Examples 17 and 18, both the filling property and the appearance of the bumps were good, the height variation σ of the bumps was 1.3 and 1.7, respectively which was small, and furthermore no voids were observed in the bumps.

On the other hand, although the surfactant (C) of Comparative Example 15 was represented by General Formula (3-2) and m was 2 which was within the appropriate range (m = 1 to 3), n was 9 which was smaller than the appropriate range (n = 10 to 30). The electroplating solution of tin alloy contained copper. In Comparative Example 15, both the filling property and the appearance of the bumps were poor, the height variation σ of the bumps was 3.9 which was large, and furthermore voids were observed in the bumps.

Although the surfactant (C) of Comparative Example 16 was represented by General Formula (3-2) and m was 2 which was within the appropriate range (m = 1 to 3), n was 31 which was greater than the appropriate range (n = 10 to 30). In Comparative Example 16, both the filling property and the appearance of the bumps were poor, the height variation σ of the bumps was 4.7 which was large, and furthermore voids were observed in the bumps.

In contrast, the surfactants (C) of Examples 19 and 21 each were represented by General Formula (3-2), m was 2 which was within the appropriate range (m = 1 to 3), and n was 10 and 30, respectively, which was within the appropriate range (n = 10 to 30). In each of Examples 19 and 21, both the filling property and the appearance of the bumps were good, the height variation σ of the bumps was 1.8 which was small, and furthermore no voids were observed in the bumps.

The surfactant (C) of Example 20 was represented by General Formula (3-2), m was 2 which was within the appropriate range (m = 1 to 3), and n was 20 which was within the appropriate range (n = 10 to 30). The electroplating solution of tin alloy contained copper. In Example 20, both the filling property and the appearance of the bumps were good, the height variation σ of the bumps was 1.3 which was small, and furthermore no voids were observed in the bumps.

As is clear from Table 3, although the surfactant (C) of Comparative Example 17 was represented by General Formula (1-3) and m was 3 which was within the appropriate range (m = 1 to 3), n was 9 which was smaller than the appropriate range (n = 10 to 30). In Comparative Example 17, both the filling property and the appearance of the bumps were poor, the height variation σ of the bumps was 3.4 which was large, and furthermore voids were observed in the bumps.

Although the surfactant (C) of Comparative Example 18 was represented by General Formula (1-3) and m was 3 which was within the appropriate range (m = 1 to 3), n was 31 which was greater than the appropriate range (n = 10 to 30). In Comparative Example 18, both the filling property and the appearance of the bumps were poor, the height variation σ of the bumps was 3.7 which was large, and furthermore voids were observed in the bumps.

In contrast, the surfactants (C) of Examples 22 to 24 each were represented by General Formula (1-3), m was 3 which was within the appropriate range (m = 1 to 3), and n was 10, 20, and 30, respectively, which was within the appropriate range (n = 10 to 30). In each of Examples 22 to 24, both the filling property and the appearance of the bumps were good, the height variation σ of the bumps was 1.3 to 2.5 which was small, and furthermore no voids were observed in the bumps.

On the other hand, although the surfactant (C) of Comparative Example 19 was represented by General Formula (2-3) and m was 3 which was within the appropriate range (m = 1 to 3), n was 9 which was smaller than the appropriate range (n = 10 to 30). In Comparative Example 19, both the filling property and the appearance of the bumps were poor, the height variation σ of the bumps was 3.8 which was large, and furthermore voids were observed in the bumps.

Although the surfactant (C) of Comparative Example 20 was represented by General Formula (2-3) and m was 3 which was within the appropriate range (m = 1 to 3), n was 31 which was greater than the appropriate range (n = 10 to 30). The electroplating solution of tin alloy contained copper. In Comparative Example 20, both the filling property and the appearance of the bumps were poor, the height variation σ of the bumps was 3.1 which was large, and furthermore voids were observed in the bumps.

In contrast, the surfactants (C) of Examples 25 and 27 each were represented by General Formula (2-3), m was 3 which was within the appropriate range (m = 1 to 3), and n was 10 and 30, respectively, which was within the appropriate range (n = 10 to 30). In Examples 25 and 27, both the filling property and the appearance of the bumps were good, the height variation σ of the bumps was 2.2 and 1.4, respectively which was small and furthermore no voids were observed in the bumps.

The surfactant (C) of Example 26 was represented by General Formula (2-3), m was 3 which was within the appropriate range (m = 1 to 3), and n was 20 which was within the appropriate range (n = 10 to 30). The electroplating solution of tin alloy contained copper. In Example 26, both the filling property and the appearance of the bumps were good, the height variation σ of the bumps was 1.0 which was small, and furthermore no voids were observed in the bumps.

On the other hand, although the surfactant (C) of Comparative Example 21 was represented by General Formula (3-3) and m was 3 which was within the appropriate range (m = 1 to 3), n was 9 which was smaller than the appropriate range (n = 10 to 30). In Comparative Example 21, both the filling property and the appearance of the bumps were poor, the height variation σ of the bumps was 4.5 which was large, and furthermore voids were observed in the bumps.

Although the surfactant (C) of Comparative Example 22 was represented by General Formula (3-3) and m was 3 which was within the appropriate range (m = 1 to 3), n was 31 which was greater than the appropriate range (n = 10 to 30). The electroplating solution of tin alloy contained silver. In Comparative Example 22, both the filling property and the appearance of the bumps were poor, the height variation σ of the bumps was 4.6 which was large, and furthermore voids were observed in the bumps.

In contrast, the surfactants (C) of Examples 28 and 30 each were represented by General Formula (3-3), m was 3 which was within the appropriate range (m = 1 to 3), and n was 10 and 30, respectively, which was within the appropriate range (n = 10 to 30). In Examples 28 and 30, both the filling property and the appearance of the bumps were good, the height variation σ of the bumps was 1.9 and 2.8, respectively which was small, and furthermore no voids were observed in the bumps.

The surfactant (C) of Example 29 was represented by General Formula (3-3), m was 3 which was within the appropriate range (m = 1 to 3), and n was 20 which was within the appropriate range (n = 10 to 30). The electroplating solution of tin alloy contained silver. In Example 29, both the filling property and the appearance of the bumps were good, the height variation σ of the bumps was 1.2 which was small, and furthermore no voids were observed in the bumps.

### Industrial Applicability

The tin or tin alloy electroplating solution of the present embodiment can be used in a step of producing a circuit substrate such as a printed circuit substrate, a flexible printed circuit substrate, and a semiconductor integrated circuit.

### Explanation of Reference Signs

1, 11: Substrate
2, 12: Solder resist layer
3: Copper seed layer
4, 15: Dry film resist layer
6, 16: Via
7, 18: Tin electroplating deposition layer (tin electroplated film)
8, 19: Tin bump
13: Copper plated layer
14: Electroless copper seed layer
17: Nickel plated layer

## Claims

1. A tin or tin alloy electroplating solution comprising:
(A) a soluble salt including at least a stannous salt;
(B) one or more compounds selected from the group consisting of an organic acid, an inorganic acid, and a salt thereof;
(C) a surfactant; and
(D) a leveling agent,
wherein the surfactant (C) is one or more selected from the group consisting of polyoxyethylene polycyclic phenyl ether sulfuric acid ester salts represented by General Formulae (1), (2), (3), and (4),
in General Formulae (1), (2), and (3), m is an integer of 1 to 3, and
in General Formulae (1), (2), (3), and (4), n is an integer of 10 to 30, and X is a cation.

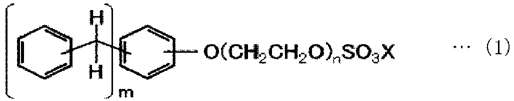

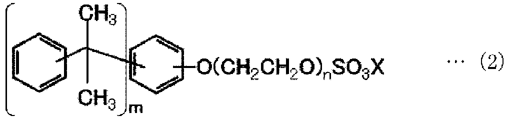

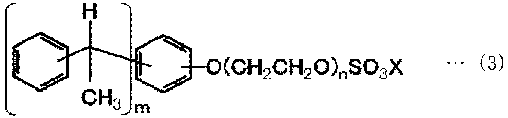

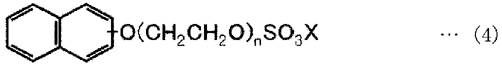

2. The tin or tin alloy electroplating solution according to Claim 1, further comprising two or more of a surfactant other than the surfactant (C), an antioxidant, and an alcohol having 1 to 4 carbon atoms.

3. A method for forming bumps, the method comprising:
a step of forming tin or tin alloy electroplating deposition layers on a substrate by using the tin or tin alloy electroplating solution according to Claim 1 or 2; and
a step of subsequently performing a reflow process to form bumps.

4. A method for producing a circuit substrate, the method comprising:
a step of producing a circuit substrate by using the bumps formed by the method according to Claim 3.
